# EUROPEAN PATENT APPLICATION

(11) **EP 4 531 251 A1**
(43) Date of publication of application: **02.04.2025**
(21) Application number: 24203105.2
(22) Date of filing: 27.09.2024
(51) Int. Cl.: H02K 11/225, H02K 21/24

(54) **AN INDUCTIVE SENSOR SYSTEM**

(30) Priority: 28.09.2023 GB 202314923
(71) Applicant: Evolito Ltd, Bicester, Oxford Oxfordshire OX25 2PA (GB)
(72) Inventor: ANTHONY, John Edward, Abingdon, OX14 3TW (GB)
(74) Representative: Marks & Clerk LLP

(57) **Abstract**

We describe an inductive sensor system for an electric machine for detecting a health parameter of the electric machine. The sensor system comprises a conductive nonmagnetic target, one or more transmitting coils for generating an alternating electro-magnetic field, one or more receiving coils configured to interact with the electro-magnetic fields generated by the transmitting coils to generate a sensing signal, and a controller coupled to the transmitting and receiving coils. The target is mounted, in use, on a rotor of the electric machine. The transmission coils and receiving coils are mounted to a substrate that is mounted, in use, to a stationary housing of the electric machine spaced axially away from the target such that the target interacts with electro-magnetic fields generated by the transmitting coils. The controller is configured to generate an alternating electro-magnetic field and to receive sensing signals from the plurality of receiving coils over a period of time. Since the received sensing signals are dependent on the presence of the target within the alternating electro-magnetic field, the controller is configured to detect a health parameter of the electric machine using the received sensing signal.

## Description

### FIELD OF THE INVENTION

The present application is directed towards a sensor system for an electric machine for detecting health parameters of the electrical machine. In particular the present invention relates to an inductive sensor for providing the same.

### BACKGROUND OF THE INVENTION

Machine condition monitoring is an important aspect of maintaining the performance and reliability of rotating machines, motors and generators. Such machines are widely used in various applications where machine failure can cause significant problems, e.g., electric vehicles, wind turbines, and industrial machinery, and particularly in the safety focused environment of aerospace.

Typically, any movement other than pure rotation of the rotor may indicate degradation, failure or other undesirable behaviour e.g., resonance. Sensor information can be used to diagnose the health of the machine during use, predict imminent failure, schedule maintenance action and provide useful data during machine design / development / test activities.

Whereas axial flux electric machines have similar challenges with respect to bearings and electric / magnetic induced vibration as for radial machines, there are additional requirements accompanying the higher torques and power densities achieved from axial flux topologies.

Condition monitoring of axial flux machines using a variety of sensor types involves measurement and analysis of various parameters, including vibration, temperature, current, and noise, to detect anomalies or deviations from normal operating conditions.

A technique used for monitoring the condition of rotating machines is vibration analysis. This technique involves measuring the vibration levels of rotating component(s) at various frequencies and analysing the spectral patterns to identify anomalies or trends. Vibration analysis can provide early warning of potential problems, such as bearing wear, misalignment, or unbalance, and can help to prevent catastrophic failures.

Another technique for condition monitoring is thermal analysis. This involves measuring the temperature of various components of a motor, such as the bearings, stator, and rotor, and analysing trends to detect abnormal heating patterns. Thermal analysis can help identify issues such as overheating due to overload or insufficient cooling and can help prevent damage to the motor.

Tiainen et al in the journal, Measurement, Volume 179, 2021, 109422, ISSN 0263-2241 teaches analysis of total rotor runout using multiple sensor probes.

It is apparent from prior art that condition monitoring is usually applied to large rotating machines on the basis such machines are often critical infrastructure e.g., generator turbines, have the space to accommodate sensors and associated wiring tails, and that several sensors are used to measure different aspects of machine health. Such multi sensor systems are challenging to implement in smaller high power dense axial flux machines and consequently effort has been given to alternative techniques to assess machine health involving no or minimal additional hardware.

Analysis of current supply / output spectra is one such health condition monitoring approach which involves assessing how machines utilise current, by analysing the amplitude and phase relationships and adherence to a nominal often predetermined sinusoidal waveform. WO2018150072A1 teaches use of differential current analysis after applying the Park Transform to determine internal and external machine faults. EP 344585A1 teaches use of the power spectral density of the Park's vector differential current, determining the amplitude of the power spectral density at a predefined frequency dependent on the rotor speed and comparing this with a predetermined power value to decide if a bearing failure is occurring.

Unfortunately, these current analysis approaches often provide information that is a second derivative from a primary cause, e.g., more power is being used than would be predicted indicating a fault, and which can be attributed to several possible primary causes.

It is apparent there is need for a high reliability, low real-estate means of axial flux electric machine condition monitoring providing primary cause / effect data.

### SUMMARY OF THE INVENTION

The present invention is defined by the independent claims, where are appended hereto. Further advantageous embodiments are provided in the dependent claims, also appended hereto.

We describe an inductive sensor system for an electric machine for detecting a health parameter of the electric machine, comprising a conductive non-magnetic target that is mounted, in use, on a rotor of the electric machine, the rotor rotating about an axis of the electric machine and the target rotating about the axis with the rotor; one or more transmitting coils for generating an alternating electro-magnetic field, the transmitting coils being mounted on a substrate that is mounted, in use, to a stationary housing of the electric machine spaced axially away from the target such that the target interacts with electro-magnetic fields generated by the transmitting coils; one or more receiving coils mounted and located on the substrate configured to interact with the electro-magnetic fields generated by the transmitting coils to generate a sensing signal; a controller coupled to the transmitting and receiving coils, the controller being configured: to generate an alternating electro-magnetic field and to receive sensing signals from the plurality of receiving coils over a period of time, the received sensing signals being dependent on the presence of the target within the alternating electro-magnetic field; and detect a health parameter of the electric machine using the received sensing signal.

Advantageously, such arrangements having a small form factor may be used to monitor the health of the electric machine over a period of time using data that is presently rejected by known systems.

One or more of the geometry of the target, arrangement of the transmission coil and arrangement of the receiving coils may be configured and arranged to provide a sinusoidal signal on the receiving coil when, in use, at least one or more portions of the target passes through the electromagnetic field generated by the transmission coils.

In a first implementation, the target may comprises a plurality of lobe portions separated by respective window portions located radially away from and centred about the axis of the rotor, the lobe portions defining portions of the target that extend radially further outwards relative to the window portions. In this implementation, the received sensing signal comprise an alternating voltage caused by the lobes and windows of the target moving through the alternating electro-magnetic field generated by the transmission coils.

In the first implementation, the controller may be configured to determine the amplitude of the alternating voltage of the received sensing signal.

A first health parameter of the electric machine may be an axial distance between the rotor of the electric machine and the stator of the electric machine. The controller may be configured to determine the first health parameter by measuring one or more peak amplitudes of the of the alternating voltage of the received sensing signal to determine an axial distance of the target from the transmission and receiving coils, the axial distance of the target from the transmission and receiving coils being indicative of the axial distance between the rotor of the electric machine and the stator of the electric machine.

A second health parameter of the electric machine nay represent a value of axial runout of the rotor of the electric machine, which is an indication of an axis of rotation of the rotor of the electric machine being tilted away from the axis of the electric machine. The controller may be configured to determine the second health parameter by using one or more of the peak amplitudes of the alternating voltages of the received sensing signal over a period of time and comparing the one or more peak amplitudes of the alternating voltages of the received sensing signal to identify fluctuations in the peak amplitudes, wherein fluctuations in the peak amplitudes are indicative of axial runout of the rotor.

The controller may be configured to determine a plurality of respective health parameters over a period of time. The controller may be configured to determine if the determined respective health parameter is within a threshold value. The controller may be configured to generate an alarm condition if a respective health parameter is greater than a respective threshold value for the respective health parameter.

In a second implementation of the inductive sensor system, the target may comprise a ring having an inner and an outer diameter, the ring mounted about the axis of the rotor, wherein the inner diameter comprises a plurality of lobe portions separated by respective window portions, the inner diameter lobe portions defining portions of the target that extend radially inwardly relative to the inner diameter window portions, wherein the outer diameter comprises a plurality of lobe portions separated by respective window portions, the outer diameter lobe portions defining portions of the target that extend radially further outwards relative to the outer diameter window portions, and wherein there are a different number of lobes on the inner and outer diameters.

In this second implementation, the receiver coil may be located radially away from the axis of the electric machine relative to the target such that the receiver coil is between the inner and outer diameters of the target. The received sensing signal may comprise an alternating voltage having a frequency caused by the lobes and windows of the target moving through the alternating electro-magnetic field generated by the transmission coils. The controller may be configured to determine one or both of respective amplitudes and respective frequencies of the alternating voltages of the received sensing signal in the frequency domain .

In this second implementation, a first health parameter of the electric machine may be an axial distance between the rotor of the electric machine and the stator of the electric machine. In this implementation, the controller may be configured to determine the first health parameter by measuring respective a DC peak magnitude of the received sensing signal in the frequency domain to determine an axial distance of the target from the transmission and receiving coils, the axial distance of the target from the transmission and receiving coils being indicative of the axial distance between the rotor of the electric machine and the stator of the electric machine.

In the second implementation, a second health parameter may be a value of axial runout of the rotor of the electric machine, the value of axial runout being indicative of an axis of rotation of the rotor of the electric machine being tilted away from the axis of the electric machine. The controller may be configured to determine the second health parameter by using a minimum and maximum peak magnitude of one or more frequency components of the received sensing signal in the frequency domain, the minimum and maximum peak magnitudes representing respectively a minimum and maximum axial distance between the rotor and stator, and wherein the controller is configured to determine a value of the axial runout based on a difference between the minimum and maximum axial distances between the rotor and stator.

In the second implementation, a third health parameter of the electric machine may represent a value of eccentricity of the rotor of the electrical machine, the value of eccentricity of the rotor of the electrical machine being indicative of an axis of rotation of the rotor of the electric machine being radially offset away from the axis of the electric machine. The controller may be configured to determine the third health parameter by using peak magnitudes and identifying respective frequency components of the received sensing signal in the frequency domain, wherein the peak magnitudes represent a value of eccentricity of the rotor and the frequency components represent a radial direction of the eccentricity of the rotor. The different number of lobes on the inner and outer diameters of the target may generate a first harmonic frequency component in the received sensing signal from the inner diameter of the target and a second harmonic frequency component from the outer diameter of the target. The controller may be configured to determine the direction of eccentricity of the rotor based on the first and second harmonic frequency components in the received sensing signal.

The controller may be configured to determine a plurality of respective health parameters over a period of time. The controller may be configured to determine if the determined respective health parameter is within a threshold value. The controller may be configured to generate an alarm condition if a respective health parameter is greater than a respective threshold value for the respective health parameter.

In any of the above with respect to the second implementation, the sensor system may comprise two or more receiving coils mounted and located on the substrate and configured to interact with the electro-magnetic fields generated by the transmitting coils to generate respective sensing signals. The two or more receiver coils may be located apart from each other and radially away from the axis of the electric machine relative to the target such that the respective receiver coils are between the inner and outer diameters of the target.

The respective received sensing signals may comprise respective alternating voltages having a frequency caused by the lobes and windows of the target moving through the alternating electro-magnetic field generated by the transmission coils. The controller may be configured to determine one or both of respective amplitudes and respective frequencies of the respective alternating voltages of the received sensing signals in the frequency domain.

In any of the above, the electrical machine may be an axial flux machine. The axial flux machine may be an axial flux motor or generator.

### LIST OF FIGURES

The present invention will be described by way of an example, and with reference to the accompanying drawings, in which:
Figures 1, 2 and 3 show schematic illustrations of a yokeless and segmented armature machine;
Figure 4 shows a schematic representation of an axial flux machine;
Figures 5a and 5b show example target forms;
Figure 6 shows an arrangement of transmission coils and receiving coils;
Figure 7 shows an outline of an axial flux machine;
Figure 8 shows an alternative embodiment of the target and receiver arrangement.

### DETAILED DESCRIPTION OF THE PREFERRED EMBODIMENTS

We will first discuss the background of the arrangement of axial flux machines, which is an example use of motor health monitoring of the present invention. Referring first to Figures 1, 2 and 3, Figure 1 shows a schematic illustration of a yokeless and segmented armature machine 10.

The machine 10 comprises a stator 12 and two rotors 14a,b. The stator 12 is a collection of separate stator bars (or pole pieces) 16 spaced circumferentially about a rotation axis 20 of the rotors 14a,b. Each bar 16 has its own axis (not shown) which is preferably, but not essentially, disposed parallel to the rotation axis 20. Each end of each stator bar is provided with a shoe 18a,b which serves a physical purpose of confining a coil stack 22, which stack 22 is preferably of square/rectangular section insulated wire so that a high fill factor can be achieved. The coils 22 are connected to an electrical circuit (not shown) that, in the case of a motor, energizes the coils so that the poles of the resultant magnetic fields generated by the current flowing in the coils is opposite in adjacent stator coils 22.

The two rotors 14a,b carry permanent magnets 24a, b that face one another with the stator coil 22 between (when the stator bars are inclined - not as shown - the magnets are likewise). Two air gaps 26a, b are disposed between respective shoe and magnet pairs 18a/24a, 18b/24b. There are a number of coils and magnets spaced around the axis of rotation 20 and, preferably, there are a different number of coils and magnets so that the coils do not all come into registration with the corresponding magnet pair at the same time and at the same rotational position of the rotor with respect to the stator. This serves to reduce cogging. The rotors are often disc-shaped and mounted near their centres and having the circumferential edge free and floating about the stator (or in the case where the rotors are annular discs comprising a hole at the centre, they are mounted relative to the stator outward of what is the central rotational axis of the rotor).

In a motor the coils 22 are energized so that their polarity alternates serving to cause coils at different times to align with different magnet pairs, resulting in torque being applied between the rotor and the stator. The rotors 14a,b are generally connected together (for example by a shaft, not shown) and rotate together about the axis 20 relative to the stator 12. The magnetic circuit 30 is provided by two adjacent stator bars 16 and two magnet pairs 24a,b and a back iron 32a,b for each rotor links the flux between the back of each magnet 24a,b facing away from the respective coils 22. The stator coils 16 are enclosed within a housing that extends through the air gap 26a, b and which defines a chamber that may be supplied with a cooling medium.

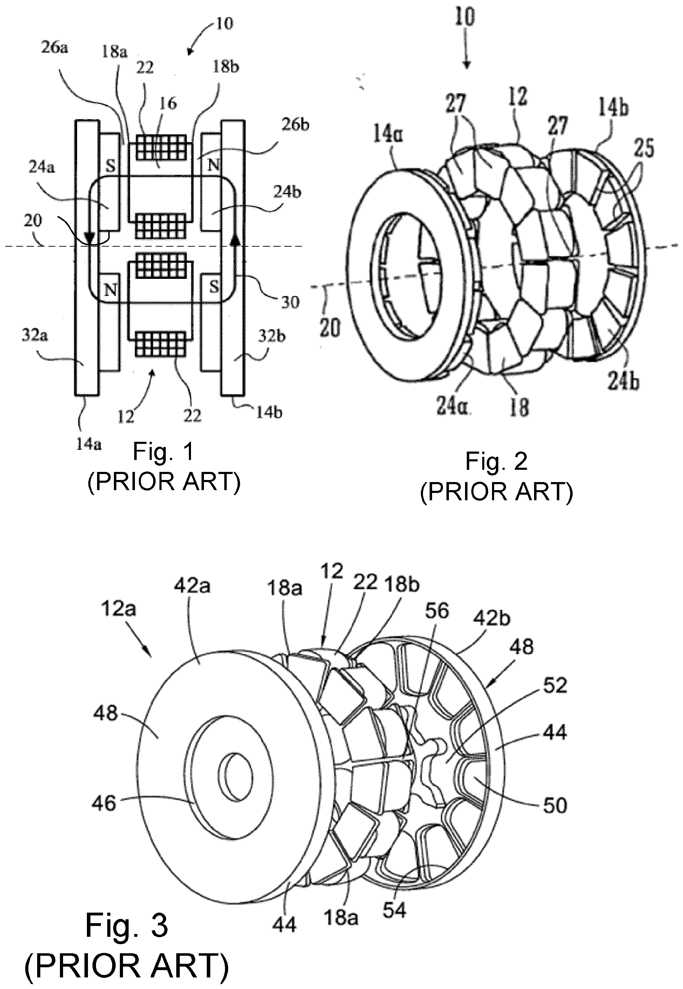

Turning to Figure 3, a stator 12a is shown in which the stator coils are located between plastic material clam shells 42a, b that form a stator housing. These clamshells have external cylindrical walls 44, internal cylindrical walls 46, and annular radially disposed walls 48. In the prior art example of Figure 3 the radial walls 48 include internal pockets 50 to receive the shoes 18a,b of the stator bars 16 and serve to locate the stator coil assemblies 16, 22, 18a,b when the two clam shell housings 42a, b of the stator 12a are assembled together. The stator housing 42a, b defines spaces 52 internally of the coils 22 and externally at 54 around the outside of the coils 22 and there are spaces 56 between the coils. The spaces 52,54,56 are interlinked defining a cooling chamber. Although not shown in Figure 3, when assembled, the stator housing 42a,b is provided with ports that allow cooling medium such as oil to be pumped into the spaces 52,54,56 to circulate around the coils and cool them.

Whilst we have described a single-stator-double-rotor embodiment, it is also possible to have an axial flux segmented armature design which comprises a single-stator-single rotor variant. In such an arrangement, a yoke is generally required in place of the removed rotor in order to complete the magnetic return path. However, the remainder of the structure remains the same as the double rotor variant.

Axial flux machines are typically of short axial length made so through having short length stators comprising armatures usually combined with a clockwise distribution of the ferromagnetic pole-piece(s) from which magnetic field is generally in the axial direction and permanent magnet rotor(s) with a generally disc shape format on which clockwise distributed magnets face along the axis opposing electro-generated armature fields. Short stators and disc rotors enable development of (axially) short high torque machines.

In brief, the present invention provides an inductive sensor system for an electric machine for detecting a health parameter of the electric machine. The sensor system comprises a conductive non-magnetic target, one or more transmitting coils for generating an alternating electro-magnetic field, one or more receiving coils configured to interact with the electro-magnetic fields generated by the transmitting coils to generate a sensing signal, and a controller coupled to the transmitting and receiving coils. The target is mounted, in use, on a rotor of the electric machine. The transmission coils and receiving coils are mounted to a substrate that is mounted, in use, to a stationary housing of the electric machine spaced axially away from the target such that the target interacts with electro-magnetic fields generated by the transmitting coils. The controller is configured to generate an alternating electro-magnetic field and to receive sensing signals from the plurality of receiving coils over a period of time. Since the received sensing signals are dependent on the presence of the target within the alternating electro-magnetic field, the controller is configured to detect a health parameter of the electric machine using the received sensing signal.

Advantageously, such arrangements having a small form factor may be used to monitor the health of the electric machine over a period of time using data that is presently rejected by known systems.

The present invention preferably uses a rotor position sensor, hereafter referred to as RPS. Accurate rotor position relative to stator armatures is required for correct and smooth operation of multiphase variable speed electric machines. An RPS can take several forms e.g., optical, electrical inductive, eddy-current and resolver i.e., electrical transformer type. Whichever approach is used, rotor position sensing is a component providing rotor position with which current is supplied to stator coils.

Though resolvers are widely used, and optical / eddy current are low cost, high frequency inductive rotor position sensing has recently found value in using printed circuit sensing coils and typically non-magnetic metallic targets which are not affected by harsh environments, a problem that besets optical devices, or stray fields, a problem associated with eddy current sensors. Inductive position sensors provide high angular resolution with a smaller footprint than resolvers.

A high electrical angle resolution for inductive sensors is particularly valuable as this leads to smoother torque delivery at high speed, an important consideration for comfort and control particularly where machines are used for traction and for ensuring long-term machine component integrity.

The present invention primarily focusses on machine health monitoring for axial flux electric machines (motors and generators), though the invention may be equally applied to radial flux topologies, and to non-electric machines having rotating components.

In the description that follows of the present invention, whenever the singular is used, it shall be deemed to include the plural, as the context requires, unless specified to be otherwise.

Previously described is a machine comprising a series of coils wound around pole pieces spaced circumferentially around the stator and spaced axially, i.e., parallel the rotational axis of the rotor. The rotor having two stages comprising discs provided with permanent magnets that face either end of each electromagnetic coil of the stator.

Rotor stages typically comprise a hub region and an annular ring, the annular ring being of soft magnetic material, i.e., a yoke, and used to convey magnetic flux between adjacent magnets, the magnets being surface mounted and spaced circumferentially around the rotor stage annular ring and disposed axially, i.e., parallel the rotation axis of the rotor. Other rotor constructions are possible that do not require a yoke.

Though the above double rotor single stator axial flux topology will be used in embodiments, the present invention is equally applicable to other axial flux topologies e.g., single stator single rotor, double stator single rotor and stacked single rotor / stator formats.

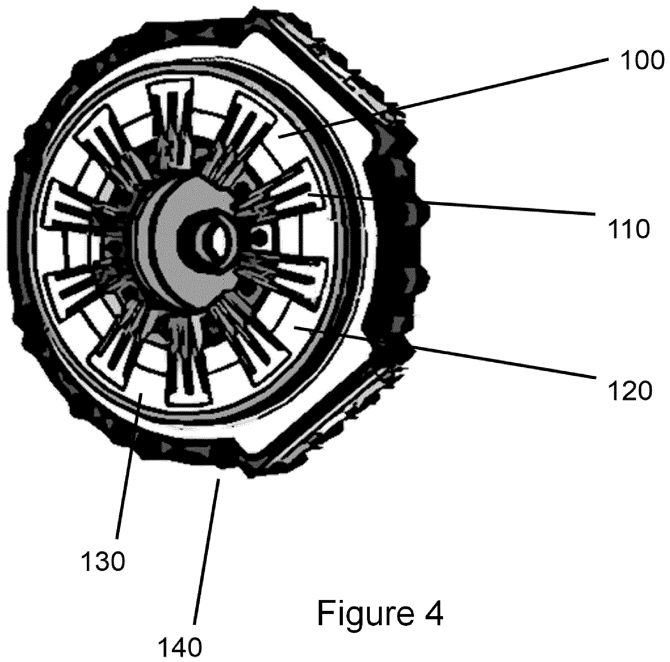

With reference to Figures 4, 5, and 6, Figure 4 shows a schematic representation of an axial flux machine with a rotor 130 and housing 140 which supports the stator (not shown). Because rotors sit close to the stator with small ~1mm real air gap, RPSs are usually placed external to the outer face the rotor 130 often housed within the rotor cover (not shown). Mounted on the rotor and rotating with it is a metallic, non-magnetic, often high conductivity RPS 'target' 100 made from e.g., copper, aluminium, steel. In the instance shown in Figure 4, the target has lobes 120 and windows 110.

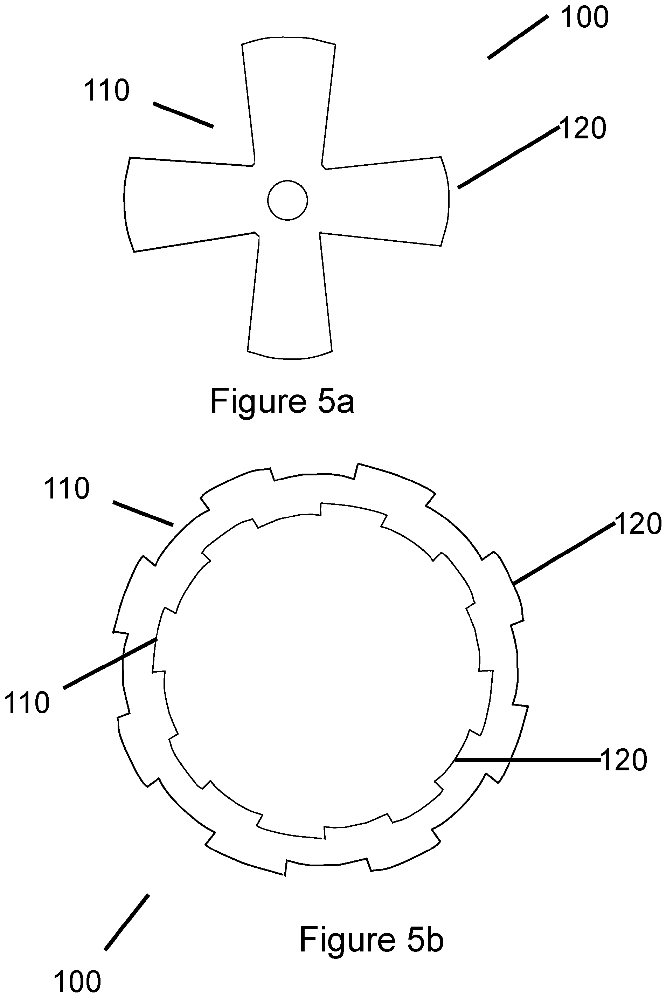

As shown in Figure 5a and Figure 5b, targets made of a conducting, and usually non-magnetic material can take different forms. We will discuss the use of these in turn below.

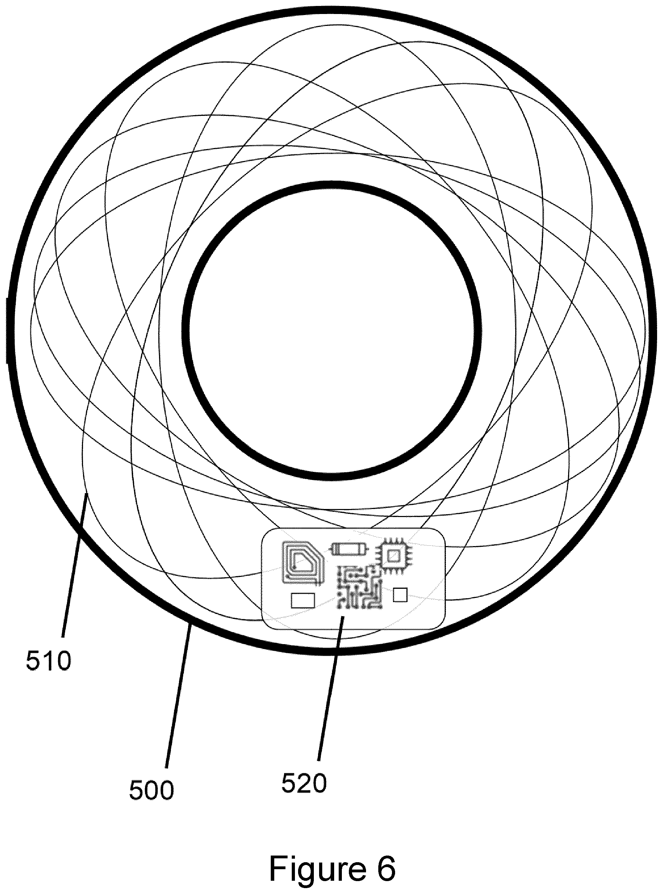

With reference to Figure 6, opposing the target 100 and in close proximity i.e., within a few millimetres and held stationary with respect to the target 100 is a PCB 500 which supports transmission ("TX") and receiver ("RX") coils 510 and usually a daughter board 520 on the PCB 500 on which is mounted the RPS control and analysis electronics.

An RPS is found in brushless axial flux machines and in the present invention the sensor is an inductive position sensor which consists of multiple sets of "coils" 510 on a PCB 500, created by etching track patterns designed using specialist software. The PCB 500 supports a transmission ("TX") coil and multiple receiver ("RX") coils. Typically, receiver coils will have at least one for a "sine" output signal and another for a "cosine" output signal; these receiver coils are physically spaced to produce output waveforms that are 90° (electrical) apart, hence their sine and cosine designations. The TX coil generates a high frequency electromagnetic field that couples into the RX coils. The stronger the coupling, the greater the voltage output from the RX coil circuitry. However, the field produced by the TX coil also interacts with a target 100 mounted adjacent to the RPS on the rotor 130. The target 100 being made of conductive material, serves to absorb the transmitted field energy. As the "lobes" 120 (see Figures 4, 5a and 5b) of the target pass over the TX/RX coils, the transmitted field is attenuated and hence the coupling to and voltage output from the RX circuitry decreases. As the "windows" 110 of the target 100 pass over the TX/RX coils, the absence of conductive target material increases the coupling to, and voltage output from, the RX circuitry. The design of the RX coils 510 and target lobes 120 and windows 110 is such that this variation results in a perfect sinusoidal voltage output from the TX circuitry, which can be used to infer the rotor position via an arctan function performed on the measured sine and cosine voltages.

Inductive rotor position sensing has several advantages over other methods of rotor position measurement (such as resolvers & encoders), including physical robustness, simplicity, low cost to manufacture, and high accuracy. It is these features that have made them appealing in industries such as automotive and in aerospace. Sensitivity to electromagnetic interference is cited as a potential weakness of inductive sensors, though this can be readily countered, and can advantageously be used in determination of electric power unit health.

A first embodiment of the present invention uses `as-supplied' inductive RPS technology to process, analyse and extract data corresponding to unintended rotor mechanical movement.

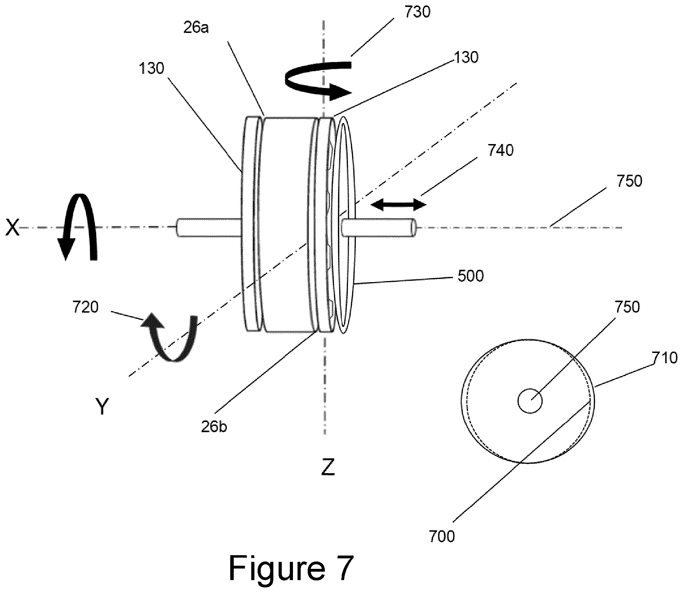

With reference to Figure 7, in this first embodiment, in addition to the normal analysing of output data to extract rotor rotational angle required for machine operation, data is further analysed and compared with a look up table of calculated or measured sensor data corresponding to optimum / predetermined desired operation i.e., pure circular 700 depicted by the dotted circle, movement of the rotor.

Advantageously non-circular movement 710 of the rotor 130 can be done in parallel to the processing normally used to extract the rotor position, so that the 'additional information' of pitch 720 and yaw 730, eccentricity and axial movement 740 of rotor 130, all relative to a nominal rotor axis 750, can be determined and the sensor target 100 and PCB 500 TX/RX coils (not shown) can continue to be used as an RPS controlling the motor as normal.

An established approach in standard RPS processing that is used to determine rotor position, troublesome noise is removed to thereby deliver `pure' sine and cosine waveforms. This is achieved by removing DC offset voltage fluctuations caused by airgap variation and rotor yaw/pitch movement. This normalisation of raw sensor data removes unwanted DC bias caused by rotor movement and normalises the sensor-to-target mounting position baseline prior to applying an arctan function, and so minimises rotor position angle error.

Such normalisation can be done in software, but advantageously is integrated into the RPS processing integrated circuit processor (IC) as an "Auto Gain Correction" (AGC) feature using circuitry inside the IC to normalise the amplitudes of the sine and cosine voltage waveforms.

However, the present invention utilises the "unwanted" noise and DC offset in order to determine one or more health parameters of the electric machine. As such, for simultaneous use of the RPS as a rotor position sensor and a rotor movement sensor, the AGC function is switched off. In the present invention, switching the AGC function off allows the voltage amplitude of the sine/cosine signals to vary with mechanical movement of the rotor target relative to the RPS, i.e., specifically looks at the 'noise' component of the RPS to decipher rotor movement. For instance, with reference to Figure 7, with the AGC turned off, the RPS provides a measurement of rotor air gap distance 26a, 26b via the amplitude of the sine/cosine voltage waveforms.

As the rotor moves [axially] closer to the RPS, the waveform amplitude increases. Conversely, as the rotor moves away from the RPS, the amplitude decreases. The relationship is approximately linear, but the exact relationship is characterized for a target / TX / RX format and this data programmed into the motor control unit as a mathematical model or lookup table to convert measured amplitude into distance. A steady but deviated (from nominal) amplitude would indicate a uniform axial shift in the rotor, either towards or away from the stator. The rotor air gap, that is the gap between the rotor and stator is thus a first health parameter that may be determined by the present invention.

A second health parameter may for example be a value of axial runout. Axial runout is indicative of an axis of rotation of the rotor of the electric machine being tilted away from the axis of the electric machine. A fluctuating amplitude would indicate rotor axial runout.

Changes in the rotor air gap, or even just the presence of axial runout conditions would imply some kind of mechanical defect or failure.

The waveform amplitude can be detected using conventional software algorithms for peak detection; this calculation is done anyway to enable amplitude normalization (performed in software) for the primary RPS function of calculating the rotor angle, and in the present instance, rather than discarding this data, it is analysed for motor health monitoring.

Because the RPS and target are usually sited on the outer facing surface of the rotor, knowing the distance between the target and the RPS is valuable because it enables the air gap on the other side of the rotor (between the stator and the magnet face) to be calculated. This is the distance of primary interest because it is typically very small (of the order of 1 mm) and any variation significantly affects motor magnetic performance. Of further concern is the possibility of mechanical failures (such as bearing failure) resulting in the air gap closing completely i.e. a rotor-to-stator "touchdown". Such an event almost always results in major damage to the motor such that it must be quickly shut down (to avoid further damage such as coolant leakage, motor disintegration, fire etc.) and completely replaced. However, despite the potential major damage resulting from this event, positively detecting touchdown can be quite difficult, since initially the friction may be modest and there is no direct torque measurement on motors (torque is inferred from the measured motor AC current). Thus, touchdown may only be detected once significant damage has occurred, for example the point at which an electrical fault occurs, coolant leaks from the stator, or heat from friction cause temperature sensors within the motor to rise to excessive levels. A further advantage of measuring axial motion is that degradation and/or impending failure can be detected before the air gap fully closes, and hence the motor can be serviced in a timely manner before any damage (and loss of propulsive power during flight) occurs.

A second embodiment recognises that existing rotor angular position sensors, particularly transmission (TX) and receiver (RX) coils are optimised for rotor angular position measurement and are not optimised for acquiring other rotor movement data.

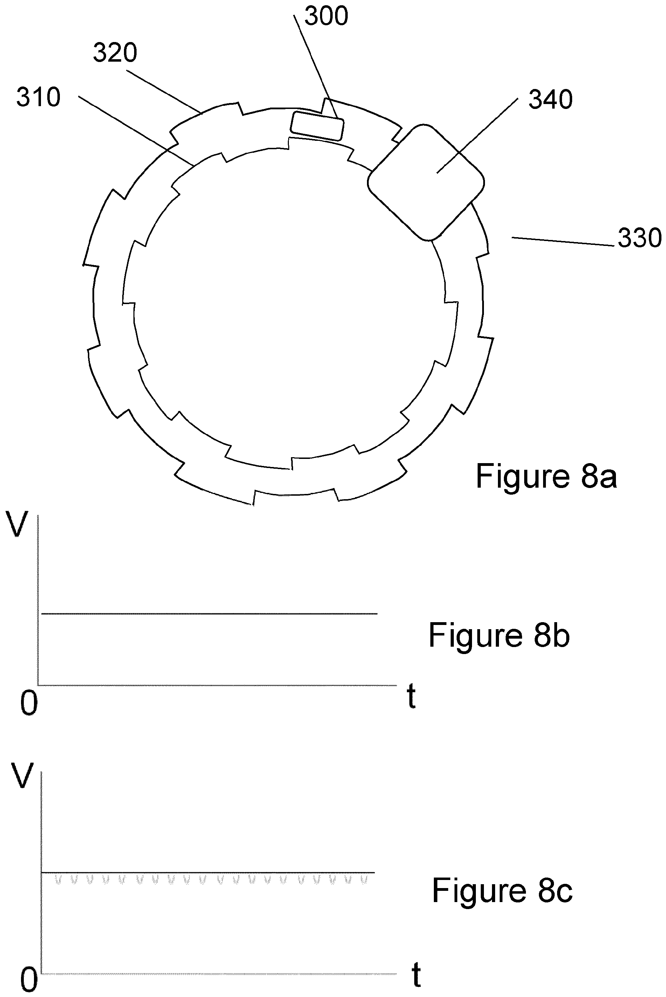

With reference to Figures 8a 8b and 8c, in this second embodiment additional transmission and receiver coils are integrated into the sensor PCB.

To prevent cross contamination of TX signals, there is value in separating coils for rotor movement i.e., movement other than planar circular rotation from the primary RPS coils 340. Rotor movement coils 300 may be placed at a greater or lesser diameter than the primary RPS coils and / or set circumferentially so that the additional rotor movement coils sit alongside the primary sensor coils but situated so they do not interfere with the primary rotor position function. Coupled with rotor movement TX and RX coils is a customized rotor target geometry 330 that is specifically designed to generate voltage output waveforms that can be analysed and processed to extract information and measurements on specific motions of the rotor, such as shift in axial position, tilt (yaw / pitch) and eccentricity.

The target shown in figures 5b and 8 show a ring form having inner and outer diameters. Each of the inner and outer diameters comprise lobes 320 and windows 310. Preferably there are a different number of lobes on the inner and outer diameters.

In the second embodiment, an RX coil 300 and / or target profile is provided yielding a constant voltage output when the rotor is in its "nominal" position with respect to the RPS, but that generates a specific waveform in the event of rotor eccentricity.

An example is shown in Figure 8. Since the RX coil 300 sits between the radii of the inner 310 and outer 320 lobes and windows of the target 330, under nominal conditions shown in Figure 8b the RX coil 300 sees a constant target surface area and hence the output would be a constant voltage that is proportional to the rotor stator gap. The rotor gap may therefore be determined by the magnitude of the constant voltage being sensed by the receiving coil.

This determination may be made from the value of the magnitude of the analogue signal itself. Alternatively, for the second embodiment, further processing steps may be implemented prior to using the sensed signal.

For example, the signal may be digitised used, for example an Analogue to Digital Converter (ADC) and then converted into a frequency spectrum signal. This may be performed using known techniques such as using Fast Fourier Transforms (FFT).

In the frequency domain, this DC signal would appear as a spike around 0Hz with a magnitude that is proportional to the rotor stator gap.

It is possible to identify rotor axial runout, which is a dynamic (time varying) motion of the rotor in the axial direction. Axial runout causes the air gap distance to vary sinusoidally with each rotor mechanical revolution. This would show in the frequency domain as a signal having a frequency that is related to the sinusoidal change in air gap, and a magnitude that is proportional to the rotor gap. To determine the axial runout, the controller may calculate the minimum and maximum air gap distances from the signals, where the difference between these is the runout (the mean would be the static air gap distance).

Since the RX coil sits between the radii of the inner and outer castellations, under nominal conditions it sees a constant target surface area (and hence would output a constant/flat voltage). A third health parameter of the rotor eccentricity may be determined. A value of eccentricity of the rotor of the electrical machine is indicative of an axis of rotation of the rotor of the electric machine being radially offset away from the axis of the electric machine. This may be caused, for example, by rotor shaft bearing wear. In this situation, the coils 300 will start to overlap lobes 310, 320 and the output waveform, shown schematically in Figure 8c, will start to feature a sinusoidal component. Due to a differing number of lobes on the inner 310 and outer 320 radii of the target 330, their generated sinusoidal frequencies will be different and hence direction of eccentric movement can be inferred.

Rather than integrating additional RX/TX coils for rotor movement into the rotor position PCB, additional RX/TX coils in their own PCB are placed and a customised rotor movement target separate from the RPS system is enabled. A separate rotor movement sensor may be housed separately to the RPS or may be integrated in the RPS package.

In embodiments subsequent processing of data is an important component of the present invention and provides opportunity for both open loop (OL) and closed loop (CL) data assessment, subsequent control to minimise vibration and crucially prediction of cause of vibration and need for maintenance or impending failure.

OL includes look-up-tables and relies on known reference data and preferably slowly moving pattern changes.

CL relies on sensor input data which can use rotor position, rotor movement and frequency to track several data streams and so react and counter vibration inputs and predict trends.

Combining OL and CL analysis and control strategies leads to a comprehensive diagnostic, mitigation and self-learning system. Of which short-term mitigation i.e., vibration reduction is important and long-term diagnostics is essential.

Whilst we have described the second embodiment with reference to a single receiver that is located between the inner and outer diameters of the specially shaped target, the sensor system may instead be provided with two or more receivers, located at different points around the electric machine housing but still between the inner and outer diameters of the target.

In such an arrangement, if the air gap varies statically around the circumference of the motor (i.e. rotor tilt) then this will result in different DC amplitudes from each RX coil, and therefore the originating rotor motion(s) can be inferred.

The signal processing steps would be similar to those discussed above for each coil, and then the magnitudes of the DC peaks would be compared between the coils to infer the rotor tilt. With the coil arrangement where there are, for example, four receivers each located approximately at 90 degree intervals around the target, the tilt in both orthogonal (X-Y) axes can be determined.

Thus, this arrangement may yield [mean] rotor air gap distance, rotor eccentricity, rotor axial runout and rotor tilt.

Whilst we have discussed specific arrangements and shapes of the target, other target arrangements and geometries would generate a useful voltage waveform. The "standard" castellation design was chosen for Figure 4 since it is known that this will produce a pure sine wave output when combined with "standard" TX/RX coil patterns as used in the industry. However, other geometries may be possible so long as the shape of the lobe and window region are capable of generating signals in the receiver coil(s) that can be analysed by the controller. A general principle of any shape of the target is that the target is preferably shaped and arranged so as to provide a sinusoidal output on the receiving coil(s) when the target passes through a region of interaction with the electromagnetic field generated by the transmission coils.

However, it is also true to say that the arrangement of transmission and receiving coils may also influence the signal on the reception coils. As such, it is preferable that the transmission and receiving coils may be arranged in a different way whilst also providing the desired sinusoidal output in the receiving coils when the suitably-shaped target passes through a region of interaction with the electromagnetic field generated by the transmission coils. Preferably, whichever arrangement is chosen, the combination of transmission and receiving coils and target are chosen so as to provide the desired sinusoidal output in the receiving coils when the target passes through a region of interaction with the electromagnetic field generated by the transmission coils.

Whilst we have discussed axial flux machines as the general case, it would be understood that such techniques and similar arrangements may be used in a radial machine topology to detect rotor eccentricity, wobble, axial movement etc.

In any of the above, the controller of the system may be configured to raise an alarm is one or more of these health parameters are greater than a threshold. This could be based on instantaneous data or from historical trends showing a gradual deterioration of the health parameter of the electrical machine. The warning may be in the form of a signal or system flag that is monitored. Other systems linked to the inductive sensor system may act on that signal or system flag as appropriate.

No doubt many other effective alternatives will occur to the skilled person. It will be understood that the invention is not limited to the described embodiments and encompasses modifications apparent to those skilled in the art lying within the scope of the claims appended hereto.

## Claims

1. An inductive sensor system for an electric machine for detecting a health parameter of the electric machine, comprising
a conductive non-magnetic target that is mounted, in use, on a rotor of the electric machine, the rotor rotating about an axis of the electric machine and the target rotating about the axis with the rotor;
one or more transmitting coils for generating an alternating electro-magnetic field, the transmitting coils being mounted on a substrate that is mounted, in use, to a stationary housing of the electric machine spaced axially away from the target such that the target interacts with electro-magnetic fields generated by the transmitting coils;
one or more receiving coils mounted and located on the substrate configured to interact with the electro-magnetic fields generated by the transmitting coils to generate a sensing signal;
a controller coupled to the transmitting and receiving coils, the controller being configured:
to generate an alternating electro-magnetic field and to receive sensing signals from the plurality of receiving coils over a period of time, the received sensing signals being dependent on the presence of the target within the alternating electro-magnetic field; and
detect a health parameter of the electric machine using the received sensing signal.

2. An inductive sensor system according to claim 1, wherein one or more of the geometry of the target, arrangement of the transmission coil and arrangement of the receiving coils are configured and arranged to provide a sinusoidal signal on the receiving coil when, in use, at least one or more portions of the target passes through the electromagnetic field generated by the transmission coils, optionally wherein the target comprises a plurality of lobe portions separated by respective window portions located radially away from and centred about the axis of the rotor, the lobe portions defining portions of the target that extend radially further outwards relative to the window portions, optionally
wherein the received sensing signal comprise an alternating voltage caused by the lobes and windows of the target moving through the alternating electro-magnetic field generated by the transmission coils.

3. An inductive sensor system according to claim 2, wherein the controller is configured to determine the amplitude of the alternating voltage of the received sensing signal, optionally
wherein a first health parameter of the electric machine is an axial distance between the rotor of the electric machine and the stator of the electric machine, wherein the controller is configured to determine the first health parameter by measuring one or more peak amplitudes of the of the alternating voltage of the received sensing signal to determine an axial distance of the target from the transmission and receiving coils, the axial distance of the target from the transmission and receiving coils being indicative of the axial distance between the rotor of the electric machine and the stator of the electric machine, and/or
wherein a second health parameter of the electric machine represents a value of axial runout of the rotor of the electric machine, the value of axial runout being indicative of an axis of rotation of the rotor of the electric machine being tilted away from the axis of the electric machine, wherein the controller is configured to determine the second health parameter by using one or more of the peak amplitudes of the alternating voltages of the received sensing signal over a period of time and comparing the one or more peak amplitudes of the alternating voltages of the received sensing signal to identify fluctuations in the peak amplitudes, wherein fluctuations in the peak amplitudes are indicative of axial runout of the rotor, and/or
wherein the controller is configured to determine a plurality of respective health parameters over a period of time.

4. An inductive sensor system according to claim 3, wherein the controller is configured to determine if the determined respective health parameter is within a threshold value, optionally
wherein the controller is configured to generate an alarm condition if a respective health parameter is greater than a respective threshold value for the respective health parameter.

5. An inductive sensor system according to claim 2, wherein the target comprises a ring having an inner and an outer diameter, the ring mounted about the axis of the rotor,
wherein the inner diameter comprises a plurality of lobe portions separated by respective window portions, the inner diameter lobe portions defining portions of the target that extend radially inwardly relative to the inner diameter window portions,
wherein the outer diameter comprises a plurality of lobe portions separated by respective window portions, the outer diameter lobe portions defining portions of the target that extend radially further outwards relative to the outer diameter window portions, and
wherein there are a different number of lobes on the inner and outer diameters.

6. An inductive sensor system according to claim 5, wherein the receiver coil is located radially away from the axis of the electric machine relative to the target such that the receiver coil is between the inner and outer diameters of the target, optionally wherein the received sensing signal comprises an alternating voltage having a frequency caused by the lobes and windows of the target moving through the alternating electro-magnetic field generated by the transmission coils, optionally
wherein the controller is configured to determine one or both of respective amplitudes and respective frequencies of the alternating voltages of the received sensing signal in the frequency domain.

7. An inductive sensor system according to claim 6, wherein a first health parameter of the electric machine is an axial distance between the rotor of the electric machine and the stator of the electric machine, wherein the controller is configured to determine the first health parameter by measuring respective a DC peak magnitude of the received sensing signal in the frequency domain to determine an axial distance of the target from the transmission and receiving coils, the axial distance of the target from the transmission and receiving coils being indicative of the axial distance between the rotor of the electric machine and the stator of the electric machine, and/or
wherein a second health parameter of the electric machine represents a value of axial runout of the rotor of the electric machine, the value of axial runout being indicative of an axis of rotation of the rotor of the electric machine being tilted away from the axis of the electric machine, wherein the controller is configured to determine the second health parameter by using a minimum and maximum peak magnitude of one or more frequency components of the received sensing signal in the frequency domain, the minimum and maximum peak magnitudes representing respectively a minimum and maximum axial distance between the rotor and stator, and wherein the controller is configured to determine a value of the axial runout based on a difference between the minimum and maximum axial distances between the rotor and stator, and/or
wherein a third health parameter of the electric machine represents a value of eccentricity of the rotor of the electrical machine, the value of eccentricity of the rotor of the electrical machine being indicative of an axis of rotation of the rotor of the electric machine being radially offset away from the axis of the electric machine, wherein the controller is configured to determine the third health parameter by using peak magnitudes and identifying respective frequency components of the received sensing signal in the frequency domain, wherein the peak magnitudes represent a value of eccentricity of the rotor and the frequency components represent a radial direction of the eccentricity of the rotor.

8. An inductive sensor system according to claim 7, wherein the different number of lobes on the inner and outer diameters of the target generate a first harmonic frequency component in the received sensing signal from the inner diameter of the target and a second harmonic frequency component from the outer diameter of the target.

9. An inductive sensor system according to claim 8, wherein the controller is configured to determine the direction of eccentricity of the rotor based on the first and second harmonic frequency components in the received sensing signal.

10. An inductive sensor system according to any one of claims 7 to 9, wherein the controller is configured to determine a plurality of respective health parameters over a period of time, and/or
wherein the controller is configured to determine if the determined respective health parameter is within a threshold value, optionally
wherein the controller is configured to generate an alarm condition if a respective health parameter is greater than a respective threshold value for the respective health parameter.

11. An inductive sensor system according to any one of claims 5 to 10, wherein the sensor system comprises two or more receiving coils mounted and located on the substrate and configured to interact with the electro-magnetic fields generated by the transmitting coils to generate respective sensing signals, optionally wherein the two or more receiver coils located apart from each other and radially away from the axis of the electric machine relative to the target such that the respective receiver coils are between the inner and outer diameters of the target.

12. An inductive sensor system according to claim 11, wherein the respective received sensing signals comprise respective alternating voltages having a frequency caused by the lobes and windows of the target moving through the alternating electro-magnetic field generated by the transmission coils, optionally
wherein the controller is configured to determine one or both of respective amplitudes and respective frequencies of the respective alternating voltages of the received sensing signals in the frequency domain.

13. An inductive sensor system according to any preceding claim, wherein the electrical machine is an axial flux machine, optionally
wherein the axial flux machine is an axial flux motor or generator.
